# EUROPEAN PATENT APPLICATION

(11) **EP 4 780 194 A2**
(43) Date of publication of application: **22.07.2026**
(21) Application number: 26150436.9
(22) Date of filing: 06.01.2026
(51) Int. Cl.: H10W 44/00, H10W 70/60, H10W 70/63, H10W 70/685, H10W 90/10, H10W 90/00

(54) **SEMICONDUCTOR DEVICE**

(30) Priority: 17.01.2025 KR 20250007556; 21.03.2025 KR 20250036625
(71) Applicant: Samsung Electronics Co., Ltd., Suwon-si, Gyeonggi-do 16677 (KR)
(72) Inventor: NAM, Seungki, 16677 Suwon-si (KR); PARK, Jiyoung, 16677 Suwon-si (KR); KIM, Taeyoon, 16677 Suwon-si (KR); HAN, Sodam, 16677 Suwon-si (KR); MOON, Sungwook, 16677 Suwon-si (KR)
(74) Representative: Marks & Clerk LLP

(57) **Abstract**

A semiconductor device is provided. The semiconductor device includes: a package substrate; an interposer provided on the package substrate; a plurality of chiplet dies provided on the interposer; and a plurality of capacitor dies provided on the interposer, the plurality of capacitor dies including a first capacitor die and a second capacitor die. The plurality of capacitor dies are provided among the plurality of chiplet dies, and a size of the first capacitor die is different from a size of the second capacitor die.

## Description

### BACKGROUND

The present disclosure relates to a semiconductor device, and more particularly, to a semiconductor device including a capacitor die.

To achieve high integration of semiconductor devices, semiconductor elements may be stacked. To enhance the immunity of semiconductor devices to power noise, on-chip decoupling capacitors may be used in the semiconductor devices, but in the case of logic chips, high-performance operation is required so that a large amount of capacitance is required.

### SUMMARY

One or more embodiments provide a semiconductor device capable of reducing power noise by securing capacitance of a decoupling capacitor. Securing capacitance may comprise, for example, providing capacitance to one or more components of a semiconductor device. The capacitance may reduce power noise.

According to an aspect of an embodiment, a semiconductor device includes: a package substrate; an interposer provided on the package substrate; a plurality of chiplet dies provided on the interposer; and a plurality of capacitor dies provided on the interposer, the plurality of capacitor dies including a first capacitor die and a second capacitor die. The plurality of capacitor dies are provided among the plurality of chiplet dies. A size of the first capacitor die is different from a size of the second capacitor die.

According to another aspect of an embodiment, a semiconductor device includes: a package substrate; an interposer provided on the package substrate; a first chiplet die provided on the interposer; a second chiplet die provided on the interposer and spaced apart from the first chiplet die; and a capacitor die provided between the first chiplet die and the second chiplet die. The capacitor die is electrically connected to the first chiplet die and the second chiplet die through a first wiring line in the interposer and a second wiring line in the package substrate.

According to another aspect of an embodiment, a semiconductor device includes: an interposer; a first chiplet die provided on the interposer; a second chiplet die provided on the interposer; and a capacitor die provided on the interposer between the first chiplet die and the second chiplet die. A plurality of isolation capacitor dies are spaced apart from one another are provided in the interposer. A first isolation capacitor die among the plurality of isolation capacitor dies is electrically connected to a first region of the first chiplet die and a first region of the second chiplet die. A second isolation capacitor die among the plurality of isolation capacitor dies is electrically connected to a second region of the first chiplet die and a second region of the second chiplet die.

The interposer may overlay at least a portion of the package substrate. The interposer may be on the package substrate in the vertical (z-axis) direction. The plurality of chiplet dies and/or the plurality of capacitor dies may overlay at least a portion of the interposer. The plurality of chiplet dies and/or the plurality of capacitor dies may be on the interposer in the vertical (z-axis) direction. The first and second chiplet dies, and the capacitor die may overlay at least a portion of the interposer. The first and second chiplet dies, and the capacitor die may be on the interposer in the vertical (z-axis) direction.

At least some of the above and other features of the disclosure are set out in the claims.

### BRIEF DESCRIPTION OF DRAWINGS

The above and other aspects will be more apparent from the following description of example embodiments, taken in conjunction with the accompanying drawings, in which:
FIG. 1 is a perspective view illustrating a semiconductor device according to an embodiment;
FIG. 2 is a plan view illustrating a layout structure of a semiconductor device according to an embodiment;
FIG. 3 illustrates an example of a cross-sectional view taken along line A1-A1' of a region A of FIG. 2;
FIG. 4 illustrates another example of a cross-sectional view taken along line A1-A1' of a region A of FIG. 2;
FIG. 5 is a circuit diagram illustrating a connection structure of a capacitor according to an embodiment;
FIG. 6 is a circuit diagram illustrating a connection structure of a capacitor according to another embodiment;
FIG. 7 is a plan view illustrating a layout structure of a semiconductor device according to an embodiment;
FIG. 8 illustrates an example of a cross-sectional view taken along line B1-B1' of a semiconductor device of FIG. 7;
FIG. 9 illustrates another example of a cross-sectional view taken along line B1-B1' of a semiconductor device of FIG. 7;
FIG. 10 is a plan view illustrating a layout structure of a chiplet die and a capacitor die according to an embodiment;
FIG. 11 illustrates an example of a cross-sectional view taken along line C1-C1' of FIG. 10;
FIG. 12 illustrates an example of a cross-sectional view taken along line D1-D1' of FIG. 10;
FIG. 13 is a block diagram illustrating a relationship between dies according to an embodiment; and
FIG. 14 is a block diagram of a system including an electronic device with a capacitor die according to embodiments.

### DETAILED DESCRIPTION

Hereinafter, various embodiments will be described in detail with reference to the accompanying drawings. Like components are denoted by like reference numerals throughout the specification, and repeated descriptions thereof are omitted. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Embodiments described herein are example embodiments, and thus, the present disclosure is not limited thereto, and may be realized in various other forms. Each embodiment provided in the following description is not excluded from being associated with one or more features of another example or another embodiment also provided herein or not provided herein but consistent with the present disclosure.

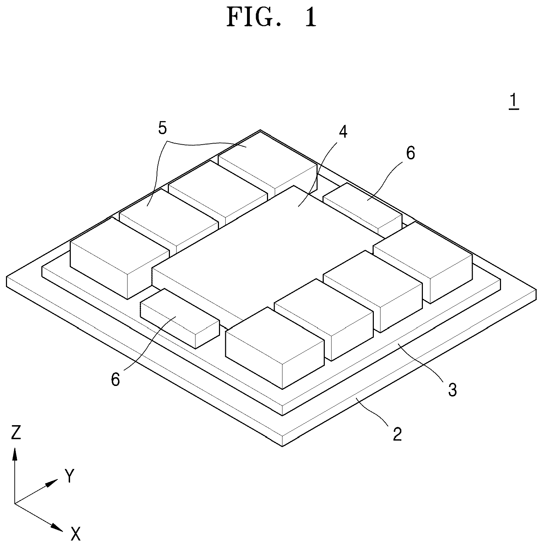

FIG. 1 is a perspective view illustrating a semiconductor device 1 according to an embodiment.

Referring to FIG. 1, the semiconductor device 1 may include a package substrate 2, an interposer 3, a first die 4, one or more second dies 5, and one or more capacitor dies 6. The semiconductor device 1 according to an example may include a semiconductor package or a 2.5D package. As another example, the semiconductor device 1 may not include a capacitor die and may include individual capacitors, but for convenience of explanation, it is assumed below that the semiconductor device 1 includes one or more capacitor dies 6.

The package substrate 2 may include a substrate including a printed circuit board (PCB), a ceramic substrate, a glass substrate, or a tape wiring substrate. As an example, the package substrate 2 may include a large-area package substrate for mounting a high-performance first die 4 and a high-performance second die 5. For example, the package substrate 2 may have a flat shape such as a square or rectangle, and a horizontal width or/and vertical width of the package substrate 2 may be 40 mm or more, but embodiments are not limited thereto.

The interposer 3 may be arranged on a top surface of the package substrate 2. The top surface of the package substrate 2 may face a bottom surface of the interposer 3. As an example, the interposer 3 may include a silicon interposer substrate including a through silicon via (TSV). As another example, the interposer 3 may include a redistribution layer (RDL) that is an organic interposer including an RDL therein. The interposer 3 may include a silicon interposer or an RDL. However, embodiments are not limited thereto. The interposer 3 includes a plurality of wiring lines and may form an electrical connection between a plurality of components arranged on the interposer 3.

As an example, the first die 4, the second die 5, and the capacitor die 6 may be mounted on the interposer 3. The first die 4, the second die 5, and the capacitor die 6 may be arranged adjacent to one another on a top surface of the interposer 3. For example, the second die 5 may be arranged adjacent to the first die 4. As an example, the capacitor die 6 may be arranged adjacent to the first die 4 and the second die 5. Adjacent may refer to adjacent each other in first and/or second horizontal directions, e.g., x and/or y-axis. As an example, the capacitor die 6 may be arranged between a plurality of second dies 5, between a plurality of first dies 4, or between the first die 4 and the second die 5. The number, sizes, and arrangement positions of first dies 4, second dies 5, and capacitor dies 6 are not limited to those illustrated in FIG. 1, and in some embodiments a dummy die may be additionally arranged.

As an example, the first die 4 may include a logic semiconductor die. For example, the first die 4 may include an application processor (AP) such as a central processing unit (CPU), a graphics processing unit (GPU), a field-programmable gate array (FPGA), a digital signal processor, an encryption processor, a microprocessor, a microcontroller, or an application-specific IC (ASIC), but is not limited thereto.

As an example, the second die 5 may include a memory semiconductor die. For example, the second die 5 may include volatile memory such as DRAM or static random access memory (SRAM), non-volatile memory such as flash memory, phase-change random access memory (PRAM), magnetoresistive random access memory (MRAM), ferroelectric random access memory (FeRAM), or resistive random access memory (RRAM), or a high-performance memory device such as high bandwidth memory (HBM) or hybrid memory cubic (HMC).

The semiconductor device 1 may additionally include an interface die for communication between dies.

For example, the first die 4 may include an ASIC such as a GPU, and the second die 5 may include stacked memory such as HBM. Such stacked memory may be in the form in which a plurality of integrated circuits are stacked. The plurality of stacked integrated circuits may be electrically connected to one another through TSVs.

As an example, a die may indicate a semiconductor chiplet die. The chiplet die may be a unit constituting a semiconductor die including one or more cores. The chiplet dies may be assembled to function as a single semiconductor die. As an example, the chiplet dies that may function as a single semiconductor die may be individualized and configured into individualized packages. As an example, a chiplet die may indicate an individual chip among chips constituting a multi-chip module (MCM). For example, a first chiplet die may include at least one of a CPU, a GPU, and a field programmable gate array (FPGA). For example, a second chiplet die may include a memory device. The number of chiplet dies mounted on the interposer 3 is not particularly limited, and a greater number of chiplet dies than those illustrated in the drawing may be mounted. The expressions chiplet die and die may be used interchangeably.

According to an example, the capacitor die 6 may be arranged between a plurality of chiplet dies and electrically connected to one or more chiplet dies. The capacitor die 6 may include one or more capacitors, and the capacitor included in the capacitor die 6 may include a decoupling capacitor. The decoupling capacitor may remove (i.e., filter) radio frequency energy injected into a power supply network, may function as a local power source to supply power, and may reduce the peak of current surge propagating across a substrate.

As an example, the capacitor die 6 may include an integrated stacked capacitor. According to an embodiment, the integrated stacked capacitor may include at least one stacked capacitor. The stacked capacitor may include a plurality of planar capacitors arranged in layers, and their electrodes may be connected in parallel. The stacked capacitor may include, for example, a crown-stacked capacitor or a raw silicon stacked capacitor. The capacitor die 6 according to an example may secure more capacitance in a limited area by including an integrated stacked capacitor. A stacked capacitor according to an example may include a high-density capacitor. As an example, the capacitor die 6 may additionally include a metal-insulator-metal (MIM) capacitor.

According to a comparative embodiment, as a plurality of chiplet dies have high performance, logic power increases which results in an increase in capacitance of the decoupling capacitor, but there are restrictions on insertion and arrangement due to the limited area of the interposer 3. By arranging the capacitor die 6 between the first die 4 and the second die 5 arranged on the interposer 3 and electrically connecting the first die 4 and the second die 5 to adjacent dies, the capacitance of the decoupling capacitor connected to the first die 4 and the second die 5 may be secured, and/or power noise may be reduced. The capacitor die 6 may be electrically connected to the first die 4 and the second die 5 through a first wiring line in the interposer 3 and a second wiring line in the package substrate 2.

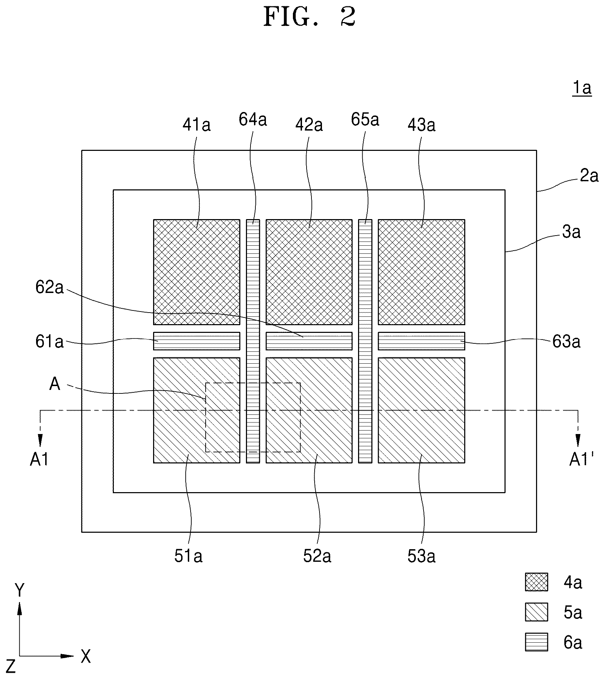

FIG. 2 is a plan view illustrating a layout structure of a semiconductor device 1a according to an embodiment.

The semiconductor device 1a may include a package substrate 2a, an interposer 3a, a plurality of first dies 4a, a plurality of second dies 5a, and a plurality of capacitor dies 6a. According to an embodiment, the interposer 3a may be arranged on the package substrate 2a. The plurality of first dies 4a, the plurality of second dies 5a, and the plurality of capacitor dies 6a may be spaced apart from one another on the interposer 3a.

As an example, the components of the semiconductor device 1a of FIG. 2 may correspond to the components of the semiconductor device 1 of FIG. 1, and repetitive descriptions of repetitive components are omitted.

As an example, the semiconductor device 1a may include three first dies 41a, 42a, and 43a, three second dies 51a, 52a, and 53a, and first to fifth capacitor dies 61a, 62a, 63a, 64a, and 65a. In the current specification, the size of a die may indicate the size of an area occupied by the die in the X-Y plane. According to an embodiment, sizes of the first dies 41a, 42a, and 43a and the second dies 51a, 52a, and 53a may be the same.

According to an embodiment, the sizes of the first to fifth capacitor dies 61a, 62a, 63a, 64a, and 65a may be partially different. As an example, the sizes and shapes of the first capacitor die 61a, the second capacitor die 62a, and the third capacitor die 63a may be the same. The sizes and shapes of the fourth capacitor die 64a and the fifth capacitor die 65a may be the same. According to an embodiment, the size and shape of the first capacitor die 61a may be different from the size and shape of the fourth capacitor die 64a. According to an embodiment, capacitance of the first capacitor die 61a may be different from capacitance of the fourth capacitor die 64a.

As an example, each of the first to fifth capacitor dies 61a, 62a, 63a, 64a, and 65a may be arranged between the first dies, between the second dies, or between the first die and the second die. As an example, the first capacitor die 61a may be arranged between the first die 41a and the second die 51a. The second capacitor die 62a may be arranged between the first die 42a and the second die 52a. The third capacitor die 63a may be arranged between the first die 43a and the second die 53a. The fourth capacitor die 64a may be arranged between the first die 41a and the first die 42a, between the second die 51a and the second die 52a, and between the first capacitor die 61a and the second capacitor die 62a. The fifth capacitor die 65a may be arranged between the first die 42a and the first die 43a, between the second die 52a and the second die 53a, and between the second capacitor die 62a and the third capacitor die 63a. Between may refer to between each other in first and/or second horizontal directions, e.g., x and/or y-axis.

The semiconductor device 1a may include capacitor dies having different sizes, shapes, and capacitance, which may be arranged in an area between the first dies and the second dies based on arrangement structures of the first dies and the second dies. The capacitor dies may be arranged in spaces among all dies requiring the decoupling capacitor. The capacitor dies may be provided among all dies, e.g., among the first dies 4a and second dies 5a, or among a plurality of chiplet dies. As an example, among may be understood to mean each or at least one of capacitor dies is arranging between at least to of the other dies (e.g., the first and/or second dies) in the horizontal (e.g., x and/or y axis) direction. By arranging the capacitor dies among the other dies, the capacitance of the capacitor dies may be secured, and/or power noise may be reduced.

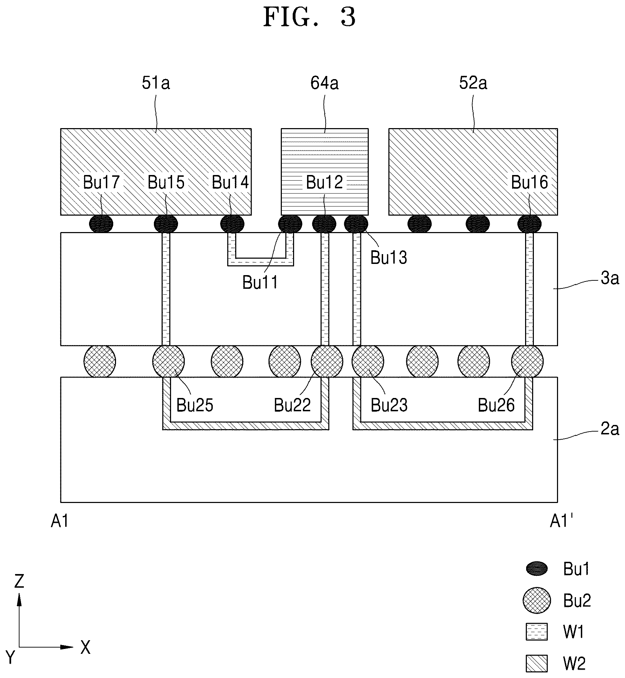

FIG. 3 illustrates an example of a cross-sectional view taken along line A1-A1' of a region A of FIG. 2.

Referring to FIG. 3, an interposer 3a is arranged on a package substrate 2a, and a second die 51a, a fourth capacitor die 64a, and a second die 52a are arranged on the interposer 3a.

According to e mbodiments, the package substrate 2a may be connected to the interposer 3a through a second bump Bu2. As an example, the second die 51a, the fourth capacitor die 64a, and the second die 52a may be connected to the interposer 3a through a first bump Bu1. The first bump Bu1 may comprise a plurality of first bumps Bu11-Bu17. The second bump Bu2 may comprise a plurality of second bumps Bu22, Bu23, Bu25, and Bu26. According to an embodiment, the fourth capacitor die 64a may be connected to the interposer 3a through first bumps Bu11, Bu12, and Bu13. In FIG. 3, a configuration in which the first bumps Bu11, Bu12, and Bu13 are connected to the fourth capacitor die 64a is disclosed, but the number of connected first bumps is not limited thereto, and the number of connected first bumps may vary according to an area in which the fourth capacitor die 64a faces the interposer 3a. As an example, each of the first bumps Bu11, Bu12, and Bu13 connected to the fourth capacitor die 64a may be electrically connected to the first bump of an adjacent die through the interposer 3a.

As an example, the first bump Bu1 and the second bump Bu2 may each include at least one of lead (Pb), tin (Sn), indium (In), bismuth (Bi), antimony (Sb), silver (Ag), and alloys thereof. However, embodiments are not limited thereto.

Referring to FIG. 3, a first wiring line W1 may be included in the interposer 3a. As an example, the interposer 3a of FIG. 3 may include an RDL interposer. The first wiring line W1 may include a wiring layer extending in an X-axis direction and a via extending in a Z-axis direction. For convenience of explanation, the wiring line extending in the X-axis direction and the via extending in the Z-axis direction in the interposer 3a are collectively referred to as the first wiring line W1. As an example, the first wiring line W1 may include a conductive material. For example, the first wiring line W1 may include at least one of copper (Cu), aluminum (Al), silver (Ag), tin (Sn), gold (Au), nickel (Ni), lead (Pb), titanium (Ti), and alloys thereof. However, embodiments are not limited thereto.

A second wiring line W2 may be included in the package substrate 2a. As an example, the second wiring line W2 may include a wiring layer extending in the X-axis direction and a via extending in the Z-axis direction. For convenience of explanation, the wiring line extending in the X-axis direction and the via extending in the Z-axis direction in the package substrate 2a are collectively referred to as the second wiring line W2. As an example, the second wiring line W2 may include a conductive material. For example, the second wiring line W2 may include at least one of Cu, Al, Ag, Sn, Au, Ni, Pb, Ti, and alloys thereof. However, embodiments are not limited thereto.

According to an embodiment, the first bump Bu11 of the fourth capacitor die 64a may be electrically connected to a first bump Bu14 of the second die 51a through the first wiring line W1 in the interposer 3a. As an example, the first bump Bu12 of the fourth capacitor die 64a may be connected to a second bump Bu22 through the first wiring line W1 of the interposer 3a, the second bump Bu22 may be connected to a second bump Bu25 through the second wiring line W2, and the second bump Bu25 may be connected to a first bump Bu15 through the first wiring line W1. In this way, the fourth capacitor die 64a may be electrically connected to the second die 51a through the interposer 3a, or may be electrically connected to the second die 51a through the interposer 3a and the package substrate 2a.

According to an embodiment, the first bump Bu13 of the fourth capacitor die 64a may be connected to a second bump Bu23 through the first wiring line W1 of the interposer 3a, the second bump Bu23 may be connected to a second bump Bu26 through the second wiring line W2, and the second bump Bu26 may be connected to a first bump Bu16 through the first wiring line W1.

According to an example of FIG. 3, the fourth capacitor die 64a may be electrically connected to adjacent second dies 51a and 52a through the interposer 3a, the package substrate 2a, the first bump Bu1, and the second bump Bu2. The fourth capacitor die 64a may be connected to an adjacent die through the second wiring line W2 of the package substrate 2a to reduce resistance of a connection path.

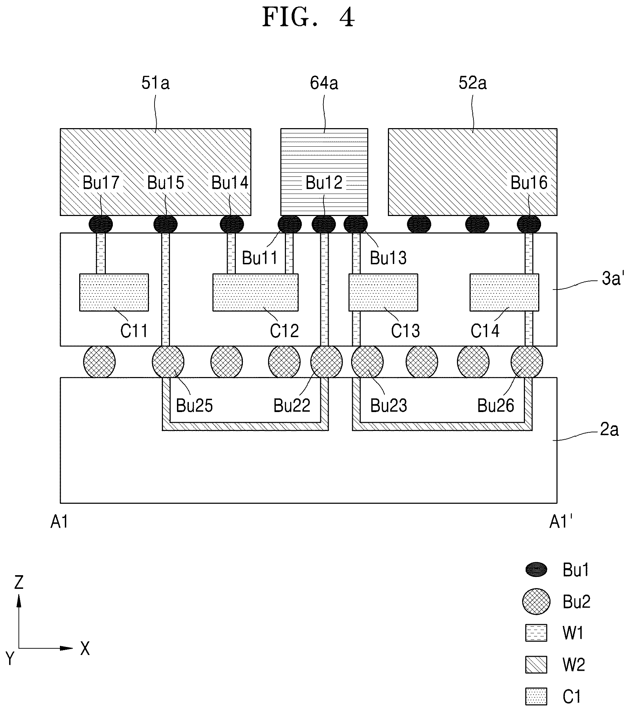

FIG. 4 illustrates another example of a cross-sectional view taken along line A1-A1' of a region A of FIG. 2.

Referring to FIG. 4, an interposer 3a' is arranged on a package substrate 2a, and a second die 51a, a fourth capacitor die 64a, and a second die 52a are arranged on the interposer 3a'. Repetitive descriptions of components corresponding to the components described with reference to FIG. 3 are omitted.

Referring to FIG. 4, the interposer 3a' may include a silicon interposer. As an example, the interposer 3a' may include a plurality of internal capacitors C1 mounted in the interposer 3a'. The plurality of internal capacitors C1 may be spaced apart from one another in the interposer 3a'. The plurality of internal capacitors C1 may include MIM capacitors. As another example, the plurality of internal capacitors C1 may include stacked capacitors. According to an embodiment, the plurality of internal capacitors C1 may be respectively connected to a plurality of chiplet dies.

Referring to FIG. 4, the first bump Bu11 of the fourth capacitor die 64a may be connected to an internal capacitor C12 through the first wiring line W1. As an example, the internal capacitor C12 may be connected to the first bump Bu14 through the first wiring line W1. As an example, the first bump Bu11 of the fourth capacitor die 64a may be electrically connected to the second die 51a through the first wiring line W1 and the internal capacitor C12. Because the second die 51a may be electrically connected to the fourth capacitor die 64a and the internal capacitor C12, not only capacitance of the fourth capacitor die 64a but also capacitance of the internal capacitor C12 in the interposer 3a' is added, Thereby, more capacitance may be secured.

The first bump Bu12 of the fourth capacitor die 64a may be connected to the second bump Bu22 through the first wiring line W1, and the second bump Bu22 may be connected to the second bump Bu25 through the second wiring line W2. The second bump Bu25 may be connected to the first bump Bu15 through the first wiring line W1. In this way, the fourth capacitor die 64a may be connected to the second die 51a through the interposer 3a' and the package substrate 2a.

The first bump Bu13 of the fourth capacitor die 64a may be connected to an internal capacitor C13 through the first wiring line W1. The internal capacitor C13 may be connected to the second bump Bu23 through the first wiring line W1. The second bump Bu23 may be connected to the second bump Bu26 through the second wiring line W2. The second bump Bu26 may be connected to an internal capacitor C14 through the first wiring line W1. The internal capacitor C14 may be connected to the first bump Bu16 through the first wiring line W1.

As an example, the second die 51a may be electrically connected to an internal capacitor C11 through a first bump Bu17 and the first wiring line W1.

According to an embodiment, the second die 51a of FIG. 4 may use a value that is the sum of capacitance of the fourth capacitor die 64a and capacitances of the internal capacitors C11 and C12 as the capacitance of the decoupling capacitor, and the second die 52a of FIG. 4 may use a value that is the sum of the capacitance of the fourth capacitor die 64a and capacitances of the internal capacitors C13 and C14 as the capacitance of the decoupling capacitor.

In this way, when the interposer 3a' is provided as a silicon interposer, the interposer 3a' may include a plurality of internal capacitors C1, and the plurality of internal capacitors C1 may be connected to dies to add capacitances.

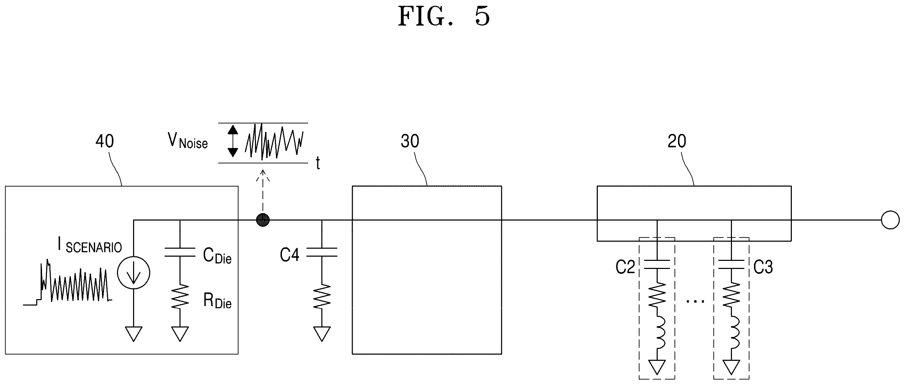

FIG. 5 is a circuit diagram illustrating a connection structure of a capacitor according to an embodiment.

Referring to FIG. 5, a block 40 corresponding to a chiplet die, a block 30 corresponding to an interposer, and a block 20 corresponding to a package substrate are provided, and examples of capacitors that may be connected to the blocks are illustrated.

As an example, the block 40 corresponding to the chiplet die may correspond to at least one of the first die 4 and the second die 5 described above, the block 30 corresponding to the interposer may correspond to the interposer 3a of FIG. 3, and the block 20 corresponding to the package substrate may correspond to the package substrate 2a described above.

As an example, the block 40 corresponding to the chiplet die may include a current source *I_{SCENARIO},* an internal die capacitor *C_{Die},* and an internal resistor *R_{Die}.* However, embodiments are not limited thereto.

According to an embodiment, the block 30 corresponding to the interposer may include an RDL interposer and thus may not include a capacitor therein. As an example, additional capacitors C2 and C3 may be arranged in the block 20 corresponding to the package substrate. As an example, capacitances of the additional capacitors C2 and C3 may be greater than capacitance of a capacitor C4.

According to an embodiment, capacitor dies may be arranged between chiplet dies on the interposer, which may be represented as the capacitor C4 of FIG. 5. As an example, the capacitor C4 may include a decoupling capacitor. According to embodiments, the capacitor C4 is arranged closest to the chiplet die and on the interposer, thereby functioning as a decoupling capacitor stably removing noise generated by the chiplet die.

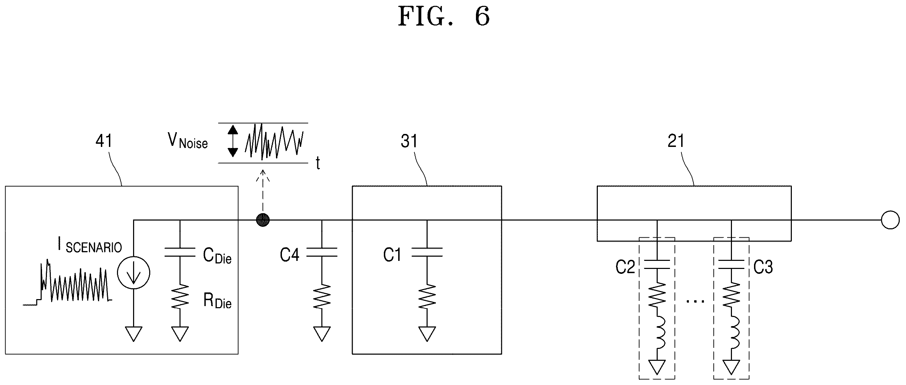

FIG. 6 is a circuit diagram illustrating a connection structure of a capacitor according to another embodiment.

Referring to FIG. 6, a block 41 corresponding to a chiplet die, a block 31 corresponding to an interposer, and a block 21 corresponding to a package substrate are provided, and examples of capacitors that may be connected to the blocks are illustrated.

As an example, the block 41 corresponding to the chiplet die may correspond to at least one of the first die 4 and the second die 5 described above, the block 31 corresponding to the interposer may correspond to the interposer 3a' of FIG. 4, and the block 21 corresponding to the package substrate may correspond to the package substrate 2a described above.

As an example, the block 41 corresponding to the chiplet die may include a current source *I_{SCENARIO},* an internal die capacitor *C_{Die},* and an internal resistor *R_{Die}.* However, embodiments are not limited thereto.

According to an embodiment, the block 31 corresponding to the interposer may include a silicon interposer and thus may include an internal capacitor C1 additionally mounted therein. As an example, additional capacitors C2 and C3 may be arranged in the block 20 corresponding to the package substrate. As an example, capacitance of the internal capacitor C1 may be less than capacitance of the capacitor C4.

According to an embodiment, capacitor dies may be arranged between chiplet dies, which may be represented as the capacitor C4 of FIG. 6. As an example, the capacitor C4 may include a decoupling capacitor. According to an embodiment, the capacitor C4 is arranged adjacent to the chiplet die and on the interposer, thereby functioning as a decoupling capacitor stably removing noise generated by the chiplet die.

Comparing FIGS. 5 and 6, the block 30 corresponding to the interposer shown in FIG. 5 is an RDL interposer and may not include an internal capacitor, and the block 31 corresponding to the interposer shown in FIG. 6 is a silicon interposer and may include an internal capacitor. Referring to FIG. 5, although the interposer includes the RDL interposer and cannot include a capacitor, noise may be reduced by securing the capacitance of the decoupling capacitor through the capacitor C4 connected adjacent to the chiplet die. Referring to FIG. 6, when the interposer includes the silicon interposer and includes an internal capacitor, in the case in which the capacitance of the decoupling capacitor is required, the capacitance of the decoupling capacitor may be additionally secured through the capacitor C4 connected adjacent to the chiplet die.

Referring to FIGS. 5 and 6, compared to the capacitors C1, C2, and C3 arranged far from the chiplet die, the effectiveness of noise reduction may increase when the capacitors C1, C2, and C3 are arranged right next to the chiplet die, and the features of FIG. 5 may also be applied to the RDL interposer without an interposer embedded capacitor solution.

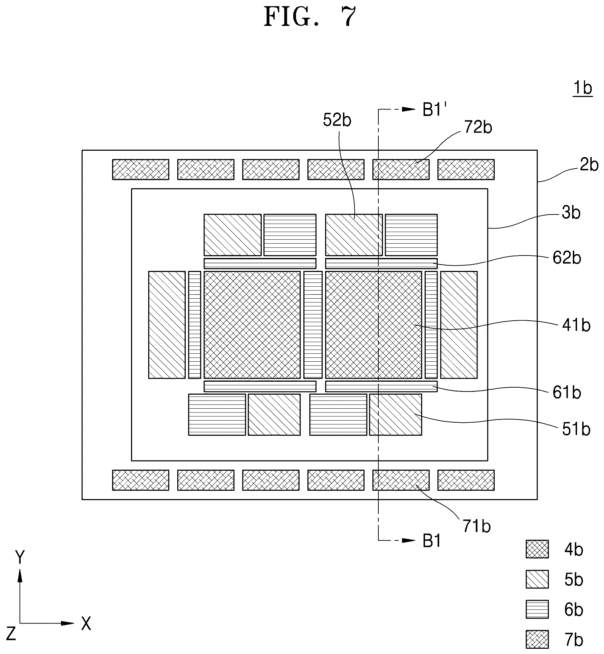

FIG. 7 is a plan view illustrating a layout structure of a semiconductor device 1b according to an embodiment.

The semiconductor device 1b of FIG. 7 may include a package substrate 2b, an interposer 3b, a plurality of first dies 4b, a plurality of second dies 5b, a plurality of capacitor dies 6b, and a plurality of additional capacitors 7b.

As an example, the interposer 3b may be arranged on the package substrate 2b. The plurality of first dies 4b, the plurality of second dies 5b, and the plurality of capacitor dies 6b may be arranged on the interposer 3b. As an example, the components of the semiconductor device 1b of FIG. 7 may correspond to the components of the semiconductor device 1 of FIG. 1 and the semiconductor device 1a of FIG. 2. Repetitive descriptions of repetitive components are omitted.

As an example, the plurality of additional capacitors 7b may be arranged on the package substrate 2b. According to an embodiment, the plurality of additional capacitors 7b may include MIM capacitors. According to an embodiment, the plurality of additional capacitors 7b may include ceramic capacitors or discrete silicon capacitors. The plurality of additional capacitors 7b may be spaced apart from one another on the package substrate 2b.

As an example, the plurality of first dies 4b may be arranged at the center of the interposer 3b, and the plurality of second dies 5b may be arranged at an edge of the interposer 3b. The plurality of second dies 5b may be arranged at positions surrounding the plurality of first dies 4b. As an example, the sizes and shapes of the plurality of first dies 4b may be different from the sizes and shapes of the plurality of second dies 5b. As an example, the sizes and shapes of the plurality of second dies 5b may vary.

The plurality of capacitor dies 6b may be arranged between the plurality of first dies 4b, between the plurality of first dies 4b and the plurality of second dies 5b, or between the plurality of second dies 5b. In an example, the plurality of capacitor dies 6b are arranged between the plurality of first 4b, between the plurality of first dies 4b and the plurality of second dies 5b, or between the plurality of second dies 5b in the horizontal (x and/or y axis) directions. It should be noted that the sizes, shapes and number of capacitor dies 6b may vary according to arrangement positions of the plurality of first dies 4b and the plurality of second dies 5b.

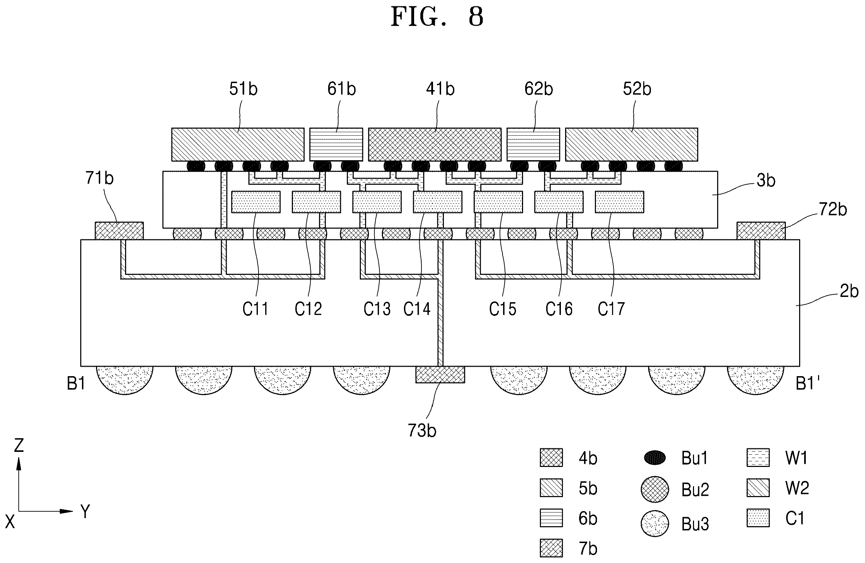

FIG. 8 illustrates an example of a cross-sectional view taken along line B1-B1' of a semiconductor device of FIG. 7.

Referring to FIG. 8, an interposer 3b is arranged on a package substrate 2b, and a first die 41b, second dies 51b and 52b, and capacitor dies 61b and 62b are arranged on the interposer 3b. The first die 41b, the second dies 51b and 52b, the capacitor dies 61b and 62b, and the interposer 3b may be connected through first bumps Bu1. The interposer 3b may be connected to the package substrate 2b through second bumps Bu2. Third balls Bu3 may be arranged under the package substrate 2b. As an example, the interposer 3b may further include a plurality of internal capacitors C11, C12, C13, C14, C15, C16, and C17 mounted therein. The interposer 3b according to an example may include a silicon interposer.

Referring to FIG. 8, the left first bump Bu1 among the two first bumps Bu1 arranged under the capacitor die 61b may be connected to the internal capacitor C12 through the first wiring line W1. The internal capacitor C12 may be connected to one or more of the first bumps Bu1 under the second die 51b through the first wiring line W1. The internal capacitor C12 may be connected to the second bump Bu2 through the first wiring line W1. According to an embodiment, the second bump Bu2 may be connected to another second bump Bu2 on the package substrate 2b through the second wiring line W2. According to an embodiment, the second bump Bu2 may be connected to an additional capacitor 71b on the package substrate 2b through the second wiring line W2. The second wiring line W2 connected to the additional capacitor 71b may be connected to one or more of the first bumps Bu1 under the second die 51b through the second bump Bu2 and the first wiring line W1. As an example, the capacitance of the decoupling capacitor of the second die 51b may be the sum of capacitance of the capacitor die 61b, capacitance of the internal capacitor C12, and capacitance of the additional capacitor 71b.

Referring to FIG. 8, the right first bump Bu1 among the two first bumps Bu1 arranged under the capacitor die 61b may be connected to the internal capacitor C13 through the first wiring line W1 and may be connected to one or more of the first bumps Bu1 arranged under the first die 41b through the first wiring line W1. According to an embodiment, the internal capacitor C13 may be connected to the second bump Bu2 through the first wiring line W1, and the second bump Bu2 may be connected to an additional capacitor 73b under the package substrate 2b through the second wiring line W2. The additional capacitor 73b may be electrically connected to the second bump Bu2 through the second wiring line W2, and the second bump Bu2 may be connected to an internal capacitor C14 through the first wiring line W1. The internal capacitor C14 may be connected to one or more of the first bumps Bu1 arranged under the first die 41b through the first wiring line W1.

Referring to FIG. 8, the left first bump Bu1 among the two first bumps Bu1 arranged under the capacitor die 62b may be connected to an internal capacitor C15 through the first wiring line W1. The internal capacitor C15 may be connected to one or more of the first bumps Bu1 under the first die 41b through the first wiring line W1. According to an embodiment, the internal capacitor C15 may be connected to the second bump Bu2 through the first wiring line W1. The second bump Bu2 may be connected to another second bump Bu2 on the package substrate 2b through the second wiring line W2, and the second bump Bu2 may be connected to an additional capacitor 72b on the package substrate 2b through the second wiring line W2. The second wiring line W2 connected to the additional capacitor 72b may be connected to one or more of the first bumps Bu1 under the first die 41b and one or more of the second die 52b through the second bumps Bu2 and the first wiring line W1. As an example, the right first bump Bu1 among the two first bumps Bu1 arranged under the capacitor die 62b may be connected to the internal capacitor C16 through the first wiring line W1. The internal capacitor C16 may be connected to one or more of the first bumps Bu1 under the second die 52b through the first wiring line W1.

As an example, capacitance of the decoupling capacitor of the first die 41b may be the sum of capacitances of the capacitor dies 61b and 62b, capacitances of the internal capacitors C13, C14, and C15, and capacitances of the additional capacitors 72b and 73b. As an example, capacitance of the decoupling capacitor of the second die 52b may be the sum of capacitance of the capacitor die 62b, capacitance of the internal capacitor C16, and capacitance of the additional capacitor 72b.

In this way, the first die 41b and the second dies 51b and 52b may be electrically connected to the capacitor of the adjacent chiplet die, the capacitor in the interposer, and the capacitor on the package substrate to secure additional capacitance of the decoupling capacitor.

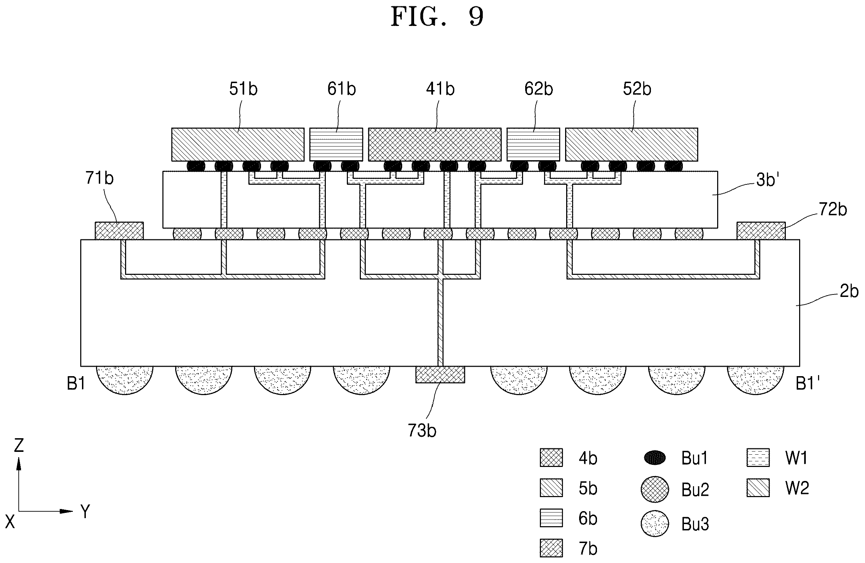

FIG. 9 illustrates another example of a cross-sectional view taken along line B1-B1' of a semiconductor device of FIG. 7.

Referring to FIG. 9, an interposer 3b' is arranged on a package substrate 2b and a first die 41b, second dies 51b and 52b, and capacitor dies 61b and 62b are arranged on the interposer 3b'. The first die 41b, the second dies 51b and 52b, and the capacitor dies 61b and 62b may be connected to the interposer 3b' through first bumps Bu1. The interposer 3b' may be connected to the package substrate 2b through second bumps Bu2. Third balls Bu3 may be arranged under the package substrate 2b. As an example, the interposer 3b' may include an RDL interposer. Accordingly, the interposer 3b' may not include an internal capacitor. In describing FIG. 9, repetitive descriptions of components that are the same as the components described with reference to FIG. 8 are omitted.

Referring to FIG. 9, the left first bump Bu1 among the first bumps arranged under the capacitor die 61b may be connected to the second bump Bu2 through the first wiring line W1 of the interposer 3b'. A second bump Bu2 may be connected to another second bump Bu2 and the additional capacitor 71b through a second wiring line W2 in the package substrate 2b. As an example, the additional capacitor 71b may be electrically connected to one or more of the first bumps Bu1 arranged under the second die 51b through the second wiring line W2, the second bump Bu2, and the first wiring line W1. Capacitance of a capacitor of the second die 51b may be the sum of capacitance of the additional capacitor 71b and capacitance of the capacitor die 61b. Accordingly, sufficient capacitance may be secured even when using an RDL interposer.

Referring to FIG. 9, the right first bump Bu1 among the first bumps arranged under the capacitor die 61b may be connected to the second bump Bu2 through the first wiring line W1 of the interposer 3b'. A second bump Bu2 may be connected to another second bump Bu2 and the additional capacitor 73b under the package substrate 2b through the second wiring line W2 in the package substrate 2b. As an example, the additional capacitor 73b may be electrically connected to one or more of the first bumps Bu1 arranged under the first die 41b through the second wiring line W2, the second bump Bu2, and the first wiring line W1.

Referring to FIG. 9, the left first bump Bu1 among the first bumps arranged under the capacitor die 62b may be connected to the second bump Bu2 through the first wiring line W1 of the interposer 3b'. A second bump Bu2 may be connected to another second bump Bu2 and the additional capacitor 73b through the second wiring line W2 in the package substrate 2b. As an example, the additional capacitor 72b may be electrically connected to one or more of the first bumps Bu1 arranged under the first die 41b and one or more of the first bumps Bu1 arranged under the second die 52b through the second wiring line W2, the second bump Bu2, and the first wiring line W1.

Referring to FIG. 9, the right first bump Bu1 among the first bumps arranged under the capacitor die 62b may be connected to the second bump Bu2 through the first wiring line W1 of the interposer 3b'. A second bump Bu2 may be connected to another second bump Bu2 and the additional capacitor 72b through the second wiring line W2 in the package substrate 2b.

Capacitance of a capacitor of the first die 41b may be the sum of capacitances of the additional capacitors 72b and 73b and capacitances of the capacitor dies 61b and 62b. Capacitance of a capacitor of the second die 52b may be the sum of capacitance of the additional capacitor 72b and capacitance of the capacitor die 62b.

In this way, the first die 41b and the second dies 51b and 52b may be electrically connected to the capacitor of the adjacent chiplet die and the capacitor on the package substrate to secure additional capacitance of the decoupling capacitor. Even when the RDL interposer is used, sufficient capacitance may be secured.

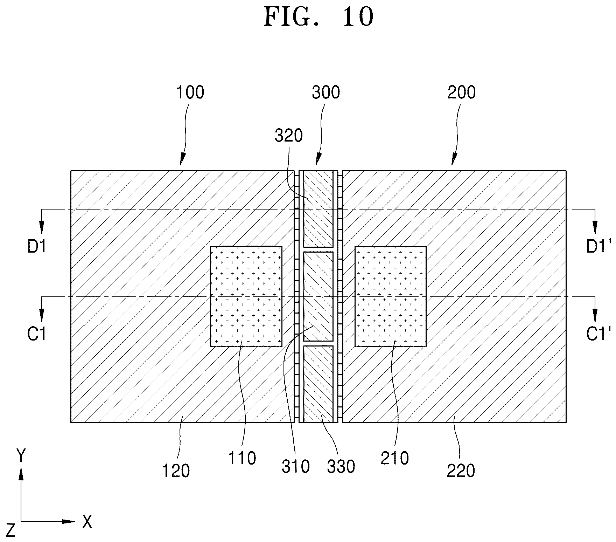

FIG. 10 is a plan view illustrating a layout structure of a chiplet die and a capacitor die according to an embodiment.

As an example, a first chiplet die 100 and a second chiplet die 200 are provided, and a capacitor die 300 arranged between the first chiplet die 100 and the second chiplet die 200 is illustrated.

Referring to FIG. 10, the first chiplet die 100 may include a first interface region 110 and a first logic region 120. The second chiplet die 200 may include a second interface region 210 and a second logic region 220. As an example, the first interface region 110 and the second interface region 210 may include a physical layer (PHY), to provide a physical interface. However, embodiments are not limited thereto. As an example, the first interface region 110 and the second interface region 210 may include a PHY or one of a link, a controller, and an adapter, and may include circuitry capable of supporting a protocol for communication between adjacent dies. As an example, the first logic region 120 and the second logic region 220 may include core logic circuits. However, embodiments are not limited thereto. As an example, the first logic region 120 and the second logic region 220 may include logic circuits such as a CPU and a GPU. As an example, the first interface region 110 and the first logic region 120 in the first chiplet die 100 may be electrically isolated. As an example, the second interface region 210 and the second logic region 220 may be electrically isolated in the second chiplet die 200.

The capacitor die 300 may include a first isolation capacitor die 310, a second isolation capacitor die 320, and a third isolation capacitor die 330. As an example, the first isolation capacitor die 310, the second isolation capacitor die 320, and the third isolation capacitor die 330 may be apart from one another in the capacitor die 300. As an example, the first isolation capacitor die 310 may be arranged corresponding to the arrangement positions of the first interface region 110 and the second interface region 210 in a second direction (Y-axis direction), and the second isolation capacitor die 320 and the third isolation capacitor die 330 may be arranged on both sides of the first isolation capacitor die 310 in the Y-axis direction.

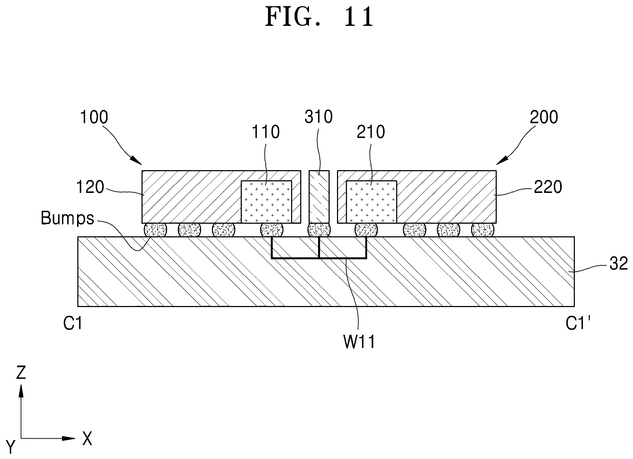

FIG. 11 illustrates an example of a cross-sectional view taken along line C1-C1' of FIG. 10.

Referring to FIG. 11, a first chiplet die 100, a first isolation capacitor die 310, and a second chiplet die 200 are arranged on an interposer 32, and the interposer 32, the first chiplet die 100, the first isolation capacitor die 310, and the second chiplet die 200 are connected through bumps Bumps.

According to an embodiment, the first isolation capacitor die 310 may be electrically connected to the first interface region 110 and the second interface region 210 through the bumps Bumps and a first wiring line W11 formed in the interposer 32. According to an embodiment, the first isolation capacitor die 310 may not be connected to the first logic region 120 and the second logic region 220, and may be electrically connected to the first and second interface regions 110 and 210 adjacent thereto.

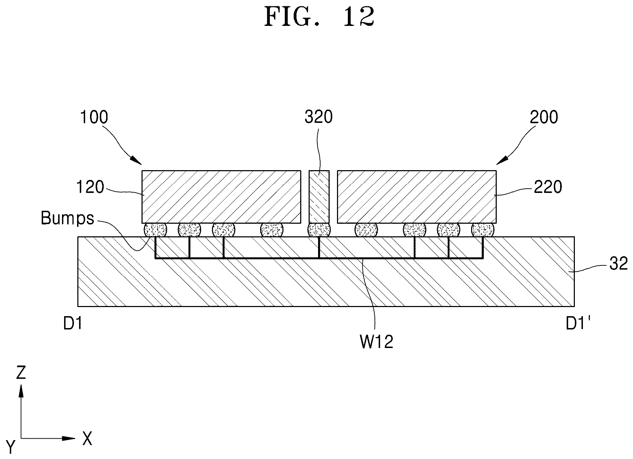

FIG. 12 illustrates an example of a cross-sectional view taken along line D1-D1' of FIG. 10.

Referring to FIG. 12, the first chiplet die 100, the second isolation capacitor die 320, and the second chiplet die 200 are arranged on the interposer 32, and the interposer 32, the first chiplet die 100, the second isolation capacitor die 320, and the second chiplet die 200 are connected through the bumps Bumps.

According to an embodiment, the second isolation capacitor die 320 may be electrically connected to the first logic region 120 and the second logic region 220 through the bumps Bumps and a first wiring line W12 formed in the interposer 32. According to an embodiment, the second isolation capacitor die 320 may not be connected to the first interface region 110 and the second interface region 210, and may be electrically connected to the first and second logic regions 120 and 220 adjacent thereto.

Referring to FIGS. 10 to 12, the capacitor die 300 according to embodiments may include the first isolation capacitor die 310, the second isolation capacitor die 320, and the third isolation capacitor die 330 that are apart and electrically separated from one another. As an example, the first isolation capacitor die 310 may be electrically connected to the first and second interface regions 110 and 210 of an adjacent chiplet die, and the second isolation capacitor die 320 and the third isolation capacitor die 330 may be electrically connected to the first and second logic regions 120 and 220 of an adjacent chiplet die. Accordingly, a single capacitor die may be connected to different components of adjacent chiplet dies. Accordingly, isolation capacitor dies may be provided that can be respectively connected to different components within a single chiplet die.

According to embodiments, the capacitor die may be applied to Internet Protocol (IP) of a small-sized die to die (D2D) interface to which the decoupling capacitor is difficult to apply for noise reduction. Referring to FIGS. 10 to 12, a small-sized IP interface may be provided to transmit and receive data between dies in a chiplet die structure. However, in this case, noise reduction may be possible without being limited by the size of the IP through an isolation capacitor die corresponding to the IP interface.

The interposer 32 in FIGS. 11 and 12 is illustrated as being an RDL interposer. However, it should be noted that such embodiments may also be applied to a silicon interposer. In addition, it should be noted that the features of FIGS. 10 to 12 may also be applied to the examples discussed above with reference to FIGS. 1 to 9.

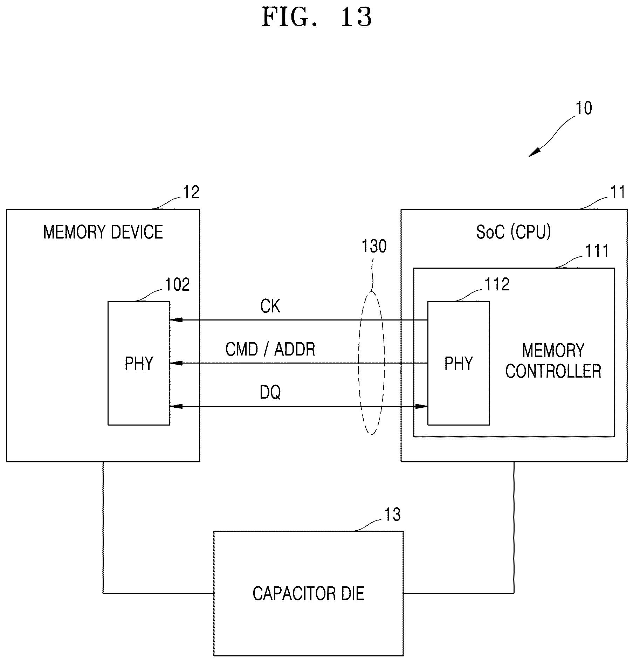

FIG. 13 is a block diagram illustrating a relationship between dies according to an embodiment.

Referring to FIG. 13, a semiconductor device 10 may include a system on chip (SoC) 11, a memory device 12, and a capacitor die 13. As an example, the SoC 11 may correspond to the first die 4 of FIG. 1, the memory device 12 may correspond to the second die 5 of FIG. 1, and the capacitor die 13 may correspond to the capacitor die 6 of FIG. 1.

The SoC 11 as a functional block performing computer operations in the semiconductor device 10 may correspond to a CPU, a GPU, a digital signal processor (DSP), or an AP.

The SoC 11 may be configured to execute one or more machine-executable instructions or pieces of software, firmware, or a combination thereof. The SoC 11 may include an arbitrary number of processor cores. For example, the SoC 11 may include a single core or may include a multi-core such as a dual core, a quad core, or a hexa core.

The memory device 12 may include HBM including a plurality of stacked memory dies. The memory device 12 may include an interface circuit 102 for performing data communication with the SoC 11. The interface circuit 102 may include physical or electrical layers and logical layers provided for signals, frequencies, timing, driving, detailed operating parameters, and functionality required for efficient communication between the SoC 11 and the memory device 12. The interface circuit 102 may perform memory interfacing, such as selecting a row and column corresponding to a memory cell, writing data to a memory cell, or reading out written data. The interface circuit 102 may support features of the HBM protocol of the joint electron device engineering council (JEDEC) standard.

The SoC 11 may include a memory controller 111 controlling the memory device 12. The memory controller 111 may include an interface circuit 112 for performing data communication with the memory device 12. The interface circuit 112 may be connected to the interface circuit 102 and may include physical or electrical layers and logical layers provided for signals, frequencies, timing, driving, detailed operating parameters, and functionality required for efficient communication between the SoC 11 and the memory device 12. The interface circuit 112 may perform memory interfacing, such as transmitting memory cell addresses and write data to the memory device 12 and receiving read data output from the memory device 12.

The interface circuit 112 may be coupled to a bus 130 carrying a clock CK, a command/address CMD/ADDR, and data DQ to channels of the memory device 12. The interface circuit 112 may communicate with the interface circuit 102 through multiple buses. The clock CK may be provided between the memory controller 111 and the memory device 12 through the bus 130. The bus 130 may include one or more signal lines to which signals are provided.

The capacitor die 13 may be electrically connected to the SoC 11 and the memory device 12 and may include a stacked capacitor in an integrated form. As an example, the capacitor die 13 may be arranged on the same plane as the SoC 11 and the memory device 12, and may be connected to the SoC 11 and the memory device 12, thereby securing the capacitances of the decoupling capacitors of the SoC 11 and the memory device 12.

In FIG. 13, the capacitor die 13 is illustrated as being connected to the SoC 11 and the memory device 12. However, the capacitor die 13 may include a plurality of isolation capacitor dies, and any one of the isolation capacitor dies may be connected to the interface circuits 102 and 112 of the SoC 11 and the memory device 12.

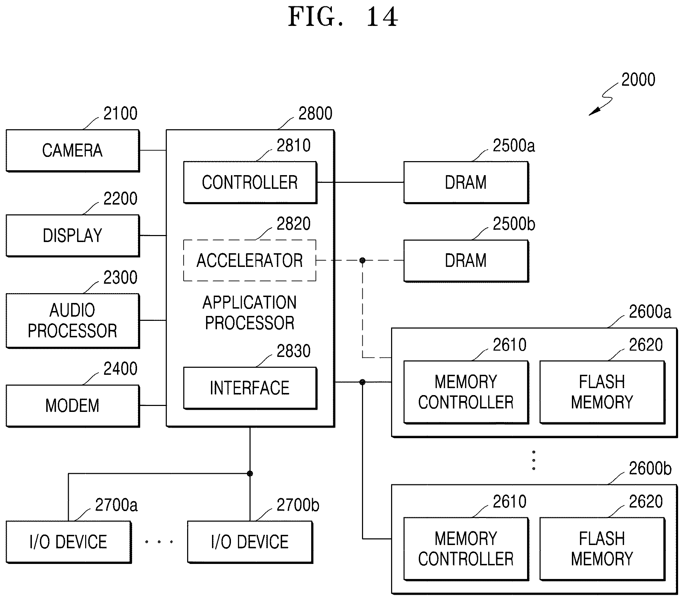

FIG. 14 is a block diagram of a system 2000 including an electronic device with a capacitor die according to embodiments.

Referring to FIG. 14, the system 2000 may include a camera 2100, a display 2200, an audio processor 2300, a modem 2400, DRAMs 2500a and 2500b, flash memories 2600a and 2600b, I/O devices 2700a and 2700b, and an AP 2800. The system 2000 may be implemented as a laptop computer, a mobile phone, a smartphone, a tablet personal computer (PC), a wearable device, a healthcare device, or an Internet of things (IoT) device. In addition, the system 2000 may be implemented as a server or a PC.

The camera 2100 may capture a still image or video by control of a user and may store captured image/video data or transmit the captured image/video data to the display 2200. The audio processor 2300 may process audio data included in the flash memories 2600a and 2600b or content of a network. The modem 2400 modulates and transmits a signal for wired/wireless data transmission and reception, and may demodulate the signal to restore the signal to the original signal at the receiving end. The I/O devices 2700a and 2700b may include devices providing digital input and/or output capabilities, such as a universal serial bus (USB), a storage, a digital camera, a secure digital (SD) card, a digital versatile disc (DVD), a network adapter, and a touch screen.

The AP 2800 may control the overall operation of the system 2000. The AP 2800 may include a control block 2810, an accelerator block or chip 2820, and an interface block 2830. The AP 2800 may control the display 2200 so that part of the content stored in the flash memories 2600a and 2600b is displayed on the display 2200. When a user input is received through the I/O devices 2700a and 2700b, the AP 2800 may perform a control operation corresponding to the user input. The AP 2800 may include an accelerator block 2820 that is a dedicated circuit for artificial intelligence (AI) data calculation, or an accelerator chip 2820 separately from the AP 2800. The DRAM 2500b may be additionally mounted in the accelerator block or chip 2820. The accelerator as a functional block specialized in performing a specific function of the AP 2800 may include a GPU that is a functional block specialized in performing graphic data processing, a neural processing unit (NPU) that is a block specialized in performing AI calculations and inference, and a data processing unit (DPU) that is a block specialized in data transmission.

The system may include a plurality of DRAMs 2500a and 2500b. The AP 2800 may control the DRAMs 2500a and 2500b through commands and mode register (MRS) settings conforming to the JEDEC standard specifications, or may communicate by setting the DRAM interface protocol to use the company's unique functions such as low voltage/high speed/reliability and cyclic redundancy check (CRC)/error correction code (ECC) functions. For example, the AP 2800 may communicate with the DRAM 2500a through an interface conforming to the JEDEC standard specifications such as LPDDR4 and LPDDR5, and the accelerator block or chip 2820 may communicate by setting a new DRAM interface specification to control the DRAM 2500b for the accelerator having a higher bandwidth than the DRAM 2500a.

In FIG. 14, only the DRAMs 2500a and 2500b are illustrated. However, embodiments are not limited thereto, and any memory such as PRAM, SRAM, MRAM, RRAM, FeRAM, or hybrid RAM may be used as long as a bandwidth, response speed, and voltage conditions of the AP 2800 or the accelerator chip 2820 are satisfied. The DRAMs 2500a and 2500b have relatively lower latency and bandwidth than the I/O devices 2700a and 2700b or the flash memories 2600a and 2600b. The DRAMs 2500a and 2500b are initialized when the system 2000 is powered on, and an operating system and application data are loaded so that the DRAMs 2500a and 2500b may be used as temporary storage locations for the operating system and application data or as execution spaces for various software code.

In the DRAMs 2500a and 2500b, arithmetic operations such as addition/subtraction/multiplication/division, vector operations, address operations, or fast Fourier transform (FFT) operations may be performed. In addition, a function for performing inference may be performed in the DRAMs 2500a and 2500b. Here, inference may be performed in a deep learning algorithm using an artificial neural network. Deep learning algorithms may include a training stage in which a model is learned through various data, and an inference stage in which data is recognized using the learned model. As an example, an image captured by a user through the camera 2100 is signal-processed and stored in the DRAM 2500b, and the accelerator block or chip 2820 may perform AI data operations recognizing data using data stored in the DRAM 2500b and a function used for inference.

The system 2000 may include a plurality of storages or a plurality of flash memories 2600a and 2600b having a larger capacitance than the DRAMs 2500a and 2500b. The accelerator block or chip 2820 may perform training stages and AI data operations by using the flash memories 2600a and 2600b. In an embodiment, the flash memories 2600a and 2600b include the memory controller 2610 and the flash memory device 2620, and may more efficiently perform the training stages and inference AI data operations performed by the AP 2800 and/or the accelerator chip 2820 by using the computational device provided in the memory controller 2610. The flash memories 2600a and 2600b may store pictures taken by the camera 2100 or data received through a data network. For example, augmented reality/virtual reality, high definition (HD), or ultra high definition (UHD) content may be stored.

In the system 2000, a capacitor die may be arranged between the AP 2800 and the DRAMs 2500a and 2500b. In addition, a capacitor die may be arranged between the memory controller 2610 and the flash memory device 2620 of the flash memories 2600a and 2600b. According to one or more embodiments, by arranging a capacitor die on an interposer and electrically connecting the capacitor die with other chiplet dies and other capacitors, capacitance of a capacitor may be secured in a limited area.

While aspects of embodiments have been particularly shown and described, it will be understood that various changes in form and details may be made therein without departing from the scope of the following claims.

Embodiments are set out in the following clauses
Clause 1: A semiconductor device comprising:
   a package substrate;
   an interposer provided on the package substrate;
   a plurality of chiplet dies provided on the interposer; and
   a plurality of capacitor dies provided on the interposer, the plurality of capacitor dies comprising a first capacitor die and a second capacitor die,
   wherein the plurality of capacitor dies are provided among the plurality of chiplet dies, and
   wherein a size of the first capacitor die is different from a size of the second capacitor die.
Clause 2: The semiconductor device of clause 1, further comprising a plurality of internal capacitors provided in the interposer,
   wherein at least one of the plurality of capacitor dies is electrically connected to at least one of the plurality of internal capacitors.
Clause 3: The semiconductor device of clause 2, wherein the interposer comprises a silicon interposer, and
   wherein the interposer electrically connects at least one of the plurality of internal capacitors to at least one of the plurality of capacitor dies and to at least one of the plurality of chiplet dies.
Clause 4: The semiconductor device of any preceding clause, wherein the interposer comprises a redistribution layer (RDL) interposer, and
   wherein the interposer electrically connects at least one of the plurality of capacitor dies to at least one of the plurality of chiplet dies.
Clause 5: The semiconductor device of any preceding clause, further comprising a plurality of additional capacitors provided on the package substrate,
   wherein at least one of the plurality of additional capacitors is electrically connected to at least one of the plurality of capacitor dies.
Clause 6: The semiconductor device of any preceding clause, wherein each of the plurality of capacitor dies comprises an integrated stacked capacitor.
Clause 7: The semiconductor device of any preceding clause, wherein each of the plurality of chiplet dies comprises:
   a logic semiconductor die;
   a memory semiconductor die; and
   an interface die.
Clause 8: A semiconductor device comprising:
   a package substrate;
   an interposer provided on the package substrate;
   a first chiplet die provided on the interposer;
   a second chiplet die provided on the interposer and spaced apart from the first chiplet die; and
   a capacitor die provided between the first chiplet die and the second chiplet die,
   wherein the capacitor die is electrically connected to the first chiplet die and the second chiplet die through a first wiring line in the interposer and a second wiring line in the package substrate.
Clause 9: The semiconductor device of clause 8, wherein the first chiplet die and the second chiplet die comprise memory semiconductor dies.
Clause 10: The semiconductor device of clause 8, wherein the first chiplet die and the second chiplet die comprise logic semiconductor dies.
Clause 11: The semiconductor device of any of clauses 8 to 10, wherein the capacitor die comprises an integrated stacked capacitor.
Clause 12: The semiconductor device of any of clauses 8 to 11, wherein the interposer comprises a silicon interposer, and
   wherein the interposer further comprises a plurality of internal capacitors.
Clause 13: The semiconductor device of clause 8, wherein the interposer comprises a redistribution layer (RDL) interposer.
Clause 14: The semiconductor device of any of clause 8 to 13, further comprising an additional capacitor provided in the package substrate,
   wherein the additional capacitor is electrically connected to at least one of the first chiplet die and the second chiplet die.
Clause 15: A semiconductor device comprising:
   an interposer;
   a first chiplet die provided on the interposer;
   a second chiplet die provided on the interposer; and
   a capacitor die provided on the interposer between the first chiplet die and the second chiplet die,
   wherein a plurality of isolation capacitor dies that are spaced apart from one another are provided in the interposer,
   wherein a first isolation capacitor die among the plurality of isolation capacitor dies is electrically connected to a first region of the first chiplet die and a first region of the second chiplet die, and
   wherein a second isolation capacitor die among the plurality of isolation capacitor dies is electrically connected to a second region of the first chiplet die and a second region of the second chiplet die.

## Claims

1. A semiconductor device (1a, 1b) comprising:
a package substrate (2a);
an interposer (3a, 3a') provided on the package substrate (2a);
a plurality of chiplet dies provided on the interposer (3a, 3a'); and
a plurality of capacitor dies (6a) provided on the interposer (3a), the plurality of capacitor dies (6a) comprising a first capacitor die and a second capacitor die,
wherein the plurality of capacitor dies (6a) are provided among the plurality of chiplet dies, and
wherein a size of the first capacitor die (61a, 62a, 63a) is different from a size of the second capacitor die (64a, 65a).

2. The semiconductor device (1a, 1b) of claim 1, further comprising a plurality of internal capacitors (C1) provided in the interposer (3a'),
wherein at least one of the plurality of capacitor dies (64a) is electrically connected to at least one of the plurality of internal capacitors (C1).

3. The semiconductor device (1a, 1b) of claim 2, wherein the interposer (3a') comprises a silicon interposer, and
wherein the interposer (3a') electrically connects at least one of the plurality of internal capacitors (C1) to at least one of the plurality of capacitor dies (64a) and to at least one of the plurality of chiplet dies (51a, 52a).

4. The semiconductor device (1a, 1b) of any preceding claim, wherein the interposer (3a, 3a') comprises a redistribution layer, RDL, interposer, and
wherein the interposer (3a, 3a') electrically connects at least one of the plurality of capacitor dies (64a) to at least one of the plurality of chiplet dies (51a, 52a).

5. The semiconductor device (1b) of any preceding claim, further comprising a plurality of additional capacitors (7b) provided on the package substrate (2b),
wherein at least one of the plurality of additional capacitors (7b) is electrically connected to at least one of the plurality of capacitor dies (6b).

6. The semiconductor device (1a, 1b) of any preceding claim, wherein each of the plurality of capacitor dies (6a, 6b) comprises an integrated stacked capacitor.

7. The semiconductor device (1a, 1b) of any preceding claim, wherein each of the plurality of chiplet dies comprises:
a logic semiconductor die;
a memory semiconductor die; and
an interface die.

8. A semiconductor device (1b) comprising:
a package substrate (2b);
an interposer (3b) provided on the package substrate (2b);
a first chiplet die (41b) provided on the interposer (3b);
a second chiplet die (51b) provided on the interposer and spaced apart from the first chiplet die; and
a capacitor die (61b) provided between the first chiplet die (41b) and the second chiplet die (52b),
wherein the capacitor die (64a) is electrically connected to the first chiplet die (41b) and the second chiplet die (51b) through a first wiring line (W1) in the interposer (3b) and a second wiring line (W2) in the package substrate (2b).

9. The semiconductor device (1b) of claim 8, wherein the first chiplet die (41b) and the second chiplet die (51b) comprise memory semiconductor dies.

10. The semiconductor device (1b) of claim 8, wherein the first chiplet die (41b) and the second chiplet die (51b) comprise logic semiconductor dies.

11. The semiconductor device (1b) of any of claims 8 to 10, wherein the capacitor die (61b) comprises an integrated stacked capacitor.

12. The semiconductor device (1b) of any of claims 8 to 11, wherein the interposer (3b) comprises a silicon interposer, and
wherein the interposer (3b) further comprises a plurality of internal capacitors (C1).

13. The semiconductor device (1b) of any of claims 8 to 11, wherein the interposer (3b) comprises a redistribution layer, RDL, interposer.

14. The semiconductor device (1b) of any of claims 8 to 13, further comprising an additional capacitor (72b) provided in the package substrate (2b),
wherein the additional capacitor (72b) is electrically connected to at least one of the first chiplet die (41b) and the second chiplet die (51b).

15. A semiconductor device comprising:
an interposer (32);
a first chiplet die (100) provided on the interposer (32);
a second chiplet die (200) provided on the interposer (32); and
a capacitor die (300) provided on the interposer (32) between the first chiplet die (100) and the second chiplet die (200),
wherein the capacitor die (300) comprises a plurality of isolation capacitor dies that are spaced apart from one another are provided on the interposer (32),
wherein a first isolation capacitor die (310) of the plurality of isolation capacitor dies is electrically connected to a first region (110) of the first chiplet die (100) and a first region (210) of the second chiplet die (200), and
wherein a second isolation capacitor die (320) of the plurality of isolation capacitor dies is electrically connected to a second region (120) of the first chiplet die (100) and a second region (220) of the second chiplet die (200).
